# EUROPEAN PATENT APPLICATION

(11) **EP 1 518 912 A1**
(43) Date of publication of application: **30.03.2005**
(21) Application number: 03733459.6
(22) Date of filing: 17.06.2003
(51) Int. Cl.: C09J 201/00, C09J 163/00, C09J 11/06, C09J 7/00, C09K 3/10, H05B 33/04, H05B 33/14

(54) **ADHESIVE FOR SEALING ORGANIC ELECTROLUMINESCENT ELEMENT AND USE THEREOF**

(30) Priority: 17.06.2002 JP 2002175965; 23.07.2002 JP 2002213909; 23.08.2002 JP 2002244204; 13.09.2002 JP 2002269069; 22.10.2002 JP 2002307393; 27.11.2002 JP 2002344510; 13.12.2002 JP 2002362714; 09.01.2003 JP 2003003572
(71) Applicant: SEKISUI CHEMICAL CO., LTD., Osaka-shi, Osaka 530-8565 (JP)
(72) Inventor: SHIMAZU, Hironobu, c/o Sekisui Chemical Co., Ltd, Mishima-gun, Osaka 618-8589 (JP); SHICHIRI, Tokushige, c/o Sekisui Chemical Co., Ltd, Mishima-gun, Osaka 618-8589 (JP)
(74) Representative: Hart Davis, Jason
(86) International application number: PCT/JP2003/007637
(87) International publication number: WO 2003/106582

(57) **Abstract**

It is an object of the present invention to provide an adhesive for sealing an organic electroluminescence device, an adhesive tape for sealing an organic electroluminescence device, a double-faced adhesive tape for sealing an organic electroluminescence device, a method of sealing an organic electroluminescence device and an organic electroluminescence device, which can seal an organic electroluminescence device without degrading it with light or heat.

The present invention relates to an adhesive for sealing an organic electroluminescence device, which comprises a photo cationic polymerizable adhesive containing a photo cationic polymerizable compound and a photo cationic polymerization initiator and, initiating a curing reaction by light irradiation and proceeding the curing reaction by a dark reaction even after interrupting the light irradiation.

## Description

### TECHNICAL FIELD

The present invention relates to an adhesive for sealing an organic electroluminescence device, an adhesive tape for sealing an organic electroluminescence device, a double-faced adhesive tape for sealing an organic electroluminescence device, a method of sealing an organic electroluminescence device and an organic electroluminescence device, which can seal an organic electroluminescence device without degrading it with light or heat.

### BACKGROUND ART

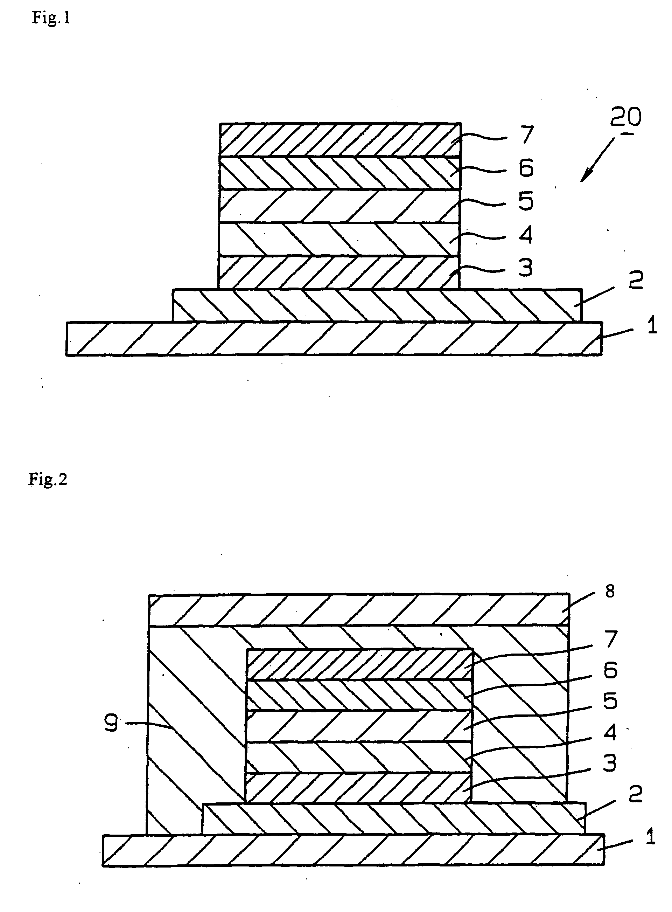

An electroluminescence device (hereinafter, referred to as an organic EL device), which uses an organic electroluminescence material (hereinafter, referred to as an organic EL material) in a luminescence layer, comprises a thin film structure in which a hole injection layer, a luminescence layer and an electron injection layer are laminated in sequence on a minus electrode generally provided on a substrate and another electrode is provided thereon. In Fig. 1, there is shown a sectional view showing schematically an example of such a thin film structure. The thin film structure 20 shown in Fig. 1 takes on a structure in which an anode 2, a hole injection electrode consisting of a hole injection layer 3 and a hole transport layer 4, an organic thin film 5 (luminescence layer), and an electron injection electrode consisting of an electron injection layer 6 and a cathode 7 are laminated in succession on a substrate 1. In addition, the structure of the thin film structure is not limited to a structure shown in Fig. 1, and for example, the organic thin film 5 may be formed at least between the anode 2 and the cathode 7, but a structure in which the hole injection layer 3, the hole transport layer 4 and the electron injection layer 6 are formed like a thin film structure 20 shown in Fig.1 is preferable from the viewpoint of improving a performance of the device.

An organic EL device comprising of such a thin film structure receive attention as one which has high visibility because of self-luminescence and high impact resistance because of a solid-state device, and realizes a DC low voltage drive device.

Formerly, the organic EL device had a problem of lacking in long storage reliability (life), which inhibits practicality, compared with an inorganic thin film device (organic-dispersed inorganic EL device) such as ZnS:Mn-based inorganic thin film device. But, in recent years, there have been advanced improvement of organic materials composing an organic thin film layer, improvement of cathode metal material and study of passivation (gas barrier film) and in environmental leaving reliability test, their characteristics have been improved, and it has been reported that its half-life in driving a device is more than 10,000 hours.

But, it cannot be said that a problem that organic solid matter, such as an emissive material, a hole injection material and an electron injection material, which are materials of an organic thin film (luminescence layer), a hole injection layer and an electron injection layer, respectively, constituting the organic EL device, tends to be affected by moisture, oxygen or the like has been perfectly resolved. And, since in opposite electrodes provided on upper and lower side of the organic solid matter, their characteristics are deteriorated due to oxidation, a luminous property is sharply reduced when the organic EL device is driven in an atmosphere. Therefore, in order to attain a practical organic EL device, it is necessary to isolate the organic solid matter and the opposite electrodes from an atmosphere so as to avoid the incursion of water content or oxygen into the organic solid matter and the oxidation of opposite electrodes to realize a long life.

As a method of isolating organic solid matter and opposite electrodes from atmosphere, there is disclosed, for example, a method of encapsulating the thin film structure with a airtight vessel of metal or glass and further placing a drying agent within the vessel in Japanese Kokai Publication Hei-9-148066. And, in Japanese Kokai Publication Hei-8-111286, there is disclosed a method of covering the surface of the thin film structure with a protective film of silicon oxide or silicon nitride, and there are disclosed a method of covering a metal electrode with an ultra violet curable resin in Japanese Kokai Publication Hei-7-192867, a method of isolating a device from an atmosphere by forming a multilayer organic and inorganic film in Japanese Kokai Publication 2000-223264, a method of isolating a device from an atmosphere with a sealing film consisting of a moisture-proof polymer film and a thermosetting adhesive layer in Japanese Kokai Publication Hei-5-101884, and a method of sealing a device by filling the space between organic EL device substrates with a light-curable adhesive and irradiating light in a upper face luminous type organic EL device in Japanese Kokai Publication 2001-357973.

However, a method of sealing with a airtight vessel had a problem that a device became more thick by providing the airtight vessel and its weight also increased. And, in a method of covering the surface of the thin film structure with a protective film of silicon oxide or silicon nitride, it was necessary to thicken a film thickness in order to prevent the occurrence of damages due to hitting a solid object in repairing the device (defective device is opened by cutting off with laser beam, etc.) or during fabrication, but when the film thickness was thickened, there was a problem that a substrate was warped because of an increased residual stress or characteristics were deteriorated due to the occurrence of cracks, and a problem that a time for forming a film was extended.

When the organic EL device is sealed with a photo-curable adhesive or a thermosetting adhesive, the organic EL device is exposed directly to light or heat in curing the adhesive, and therefore there was a problem that a performance of the device tends to be reduced, and deteriorates in some cases. And, in the case of using the photo-curable adhesive, there were problems that gas generated in irradiating light fills the inside of the device and accelerates the deterioration of the device or curing of the photo-curable adhesive becomes insufficient when there is a part to which light is not irradiated due to a metal wire or when a substrate containing an ultraviolet absorber is sealed.

### SUMMARY OF THE INVENTION

It is an object of the present invention to provide an adhesive for sealing an organic electroluminescence device, an adhesive tape for sealing an organic electroluminescence device, a double-faced adhesive tape for sealing an organic electroluminescence device, a method of sealing an organic electroluminescence device and an organic electroluminescence device, which can seal an organic electroluminescence device without degrading it with light or heat.

The first present invention pertains to an adhesive for sealing an organic electroluminescence device, which comprises a photo cationic polymerizable adhesive containing a photo cationic polymerizable compound and a photo cationic polymerization initiator, initiating a curing reaction by light irradiation and proceeding the curing reaction by a dark reaction even after interrupting the light irradiation.

The above-mentioned photo cationic polymerizable compound is preferably an aromatic epoxy resin. And, the above-mentioned photo cationic polymerization initiator is preferably a salt containing boronic acid expressed by the following formula (1) as a counter ion.

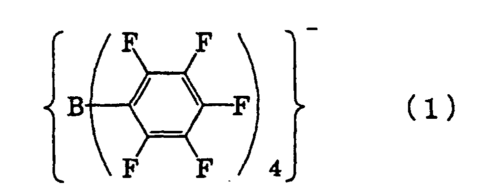

Further, the above-mentioned photo cationic polymerization initiator is preferably a reaction product of a compound containing at least one hydroxyl group in a molecule and producing an acid by light irradiation and a compound containing two or more functional group being reactive with a hydroxyl group in a molecule, and more preferably a reaction product of a compound containing two or more hydroxyl groups in a molecule and producing an acid by light irradiation and carboxylic anhydride or dicarboxylic acid.

The above-mentioned photo cationic polymerizable adhesive preferably contains aliphatic hydrocarbon having a hydroxyl group and/or a polyether compound, and preferably contains a filler, and preferably contains an alkaline filler being reactive with acid and/or an ion-exchange resin adsorbing acid, and preferably contains a drying agent.

A method of sealing an organic electroluminescence device using the adhesive for sealing an organic electroluminescence device of the first present invention, in which after irradiating light to the above adhesive for sealing an organic electroluminescence device, the device is sealed by filling the space between a sealing plate and a thin film structure with the above adhesive for sealing an organic electroluminescence device before the above adhesive for sealing an organic electroluminescence device is cured, also constitutes the present invention. A method of sealing an organic electroluminescence device using the adhesive for sealing an organic electroluminescence device of the first present invention, in which after irradiating light to the above adhesive for sealing an organic electroluminescence device, the device is sealed by applying the above adhesive for sealing an organic electroluminescence device so as to seal the periphery of the thin film structure and bonding the sealing plate to the applied adhesive before the above adhesive for sealing an organic electroluminescence device is cured, also constitutes the present invention.

The second present invention pertains to an adhesive tape for sealing an organic electroluminescence device, which has a moisture-proof tape and an adhesive layer comprising the adhesive for sealing an organic electroluminescence device of the first present invention formed on at least one side of the moisture-proof tape. Preferably, the above-mentioned adhesive layer has the water vapor transmission rate, measure by a dish method based on JIS Z 0208 under the conditions of 60°C and 90% relative humidity (RH), of 30 g/(m²·24h)/100 µm or less. It is preferred to have a drying agent in sheet form in the above adhesive layer.

A method of sealing an organic electroluminescence device using the adhesive tape for sealing an organic electroluminescence device of the second present invention, in which after irradiating light to the adhesive layer of the above adhesive tape for sealing an organic electroluminescence device, the device is sealed by bonding the adhesive tape onto the thin film structure before the adhesive layer is cured, also constitutes the present invention.

The third present invention pertains to a double-faced adhesive tape for sealing an organic electroluminescence device, which has an adhesive layer comprising the adhesive for sealing an organic electroluminescence device of the first present invention and separators formed on both sides of the above adhesive layer. Preferably, the above adhesive layer has the water vapor transmission rate, measure by a dish method based on JIS Z 0208 under the conditions of 60°C and 90% relative humidity (RH), of 30 g/(m²·24h)/100 µm or less.

A method of sealing an organic electroluminescence device using the double-faced adhesive tape for sealing an organic electroluminescence device of the third present invention, in which after peeling off one separator of the above double-faced adhesive tape for sealing an organic electroluminescence device and irradiating light to the adhesive layer on the side on which the above separator has been peeled off, the device is sealed by bonding the above double-faced adhesive tape for sealing an organic electroluminescence device so as to seal the periphery of the thin film structure and peeling off the other separator of the above double-faced adhesive tape for sealing an organic electroluminescence device and further coating the above adhesive layer with a sealing plate before the above adhesive layer is cured, also constitutes the present invention.

An organic electroluminescence device, which is sealed by using the adhesive for sealing an organic electroluminescence device of the first present invention, the adhesive tape for sealing an organic electroluminescence device of the second present invention, or the double-faced adhesive tape for sealing an organic electroluminescence device of the third present invention, also constitutes the present invention.

### BRIEF DESCRIPTION OF THE DRAWINGS

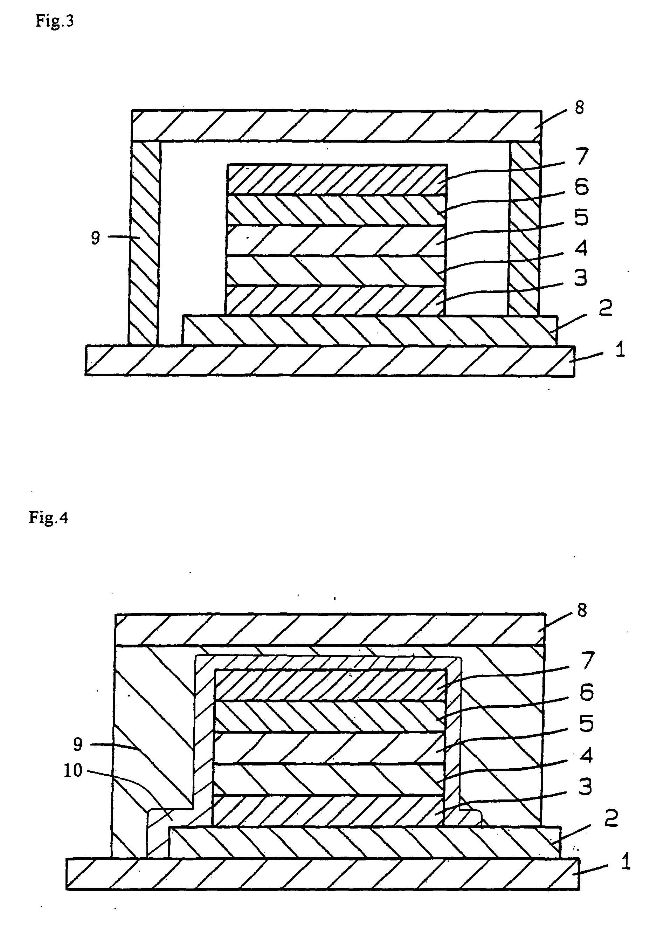

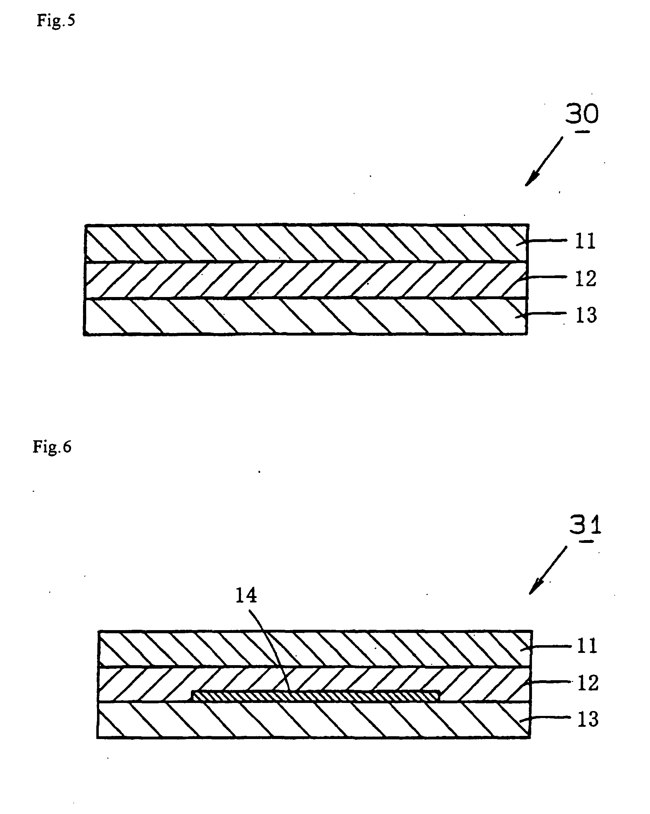

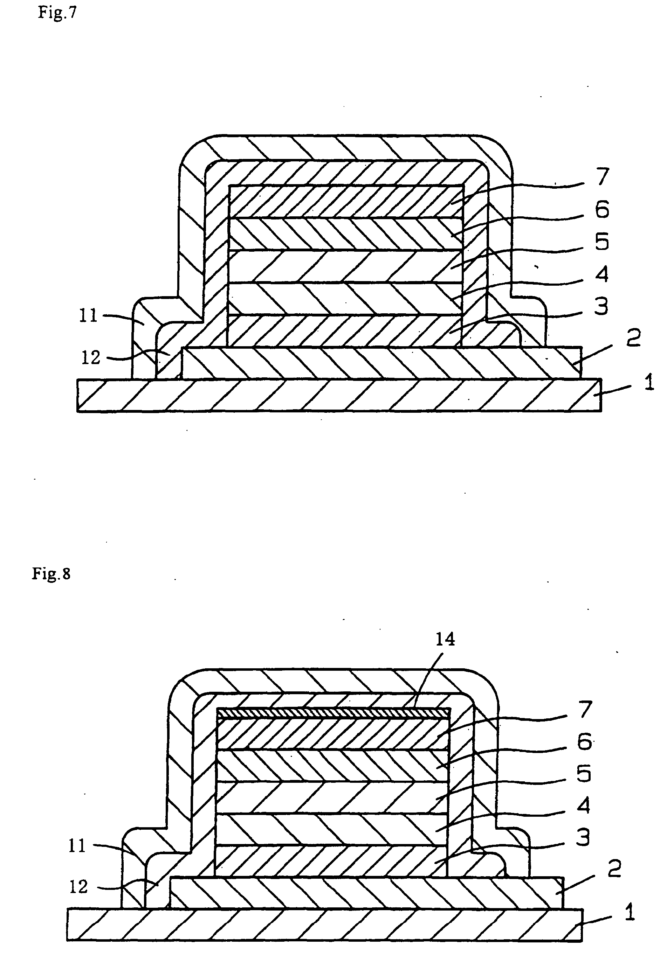

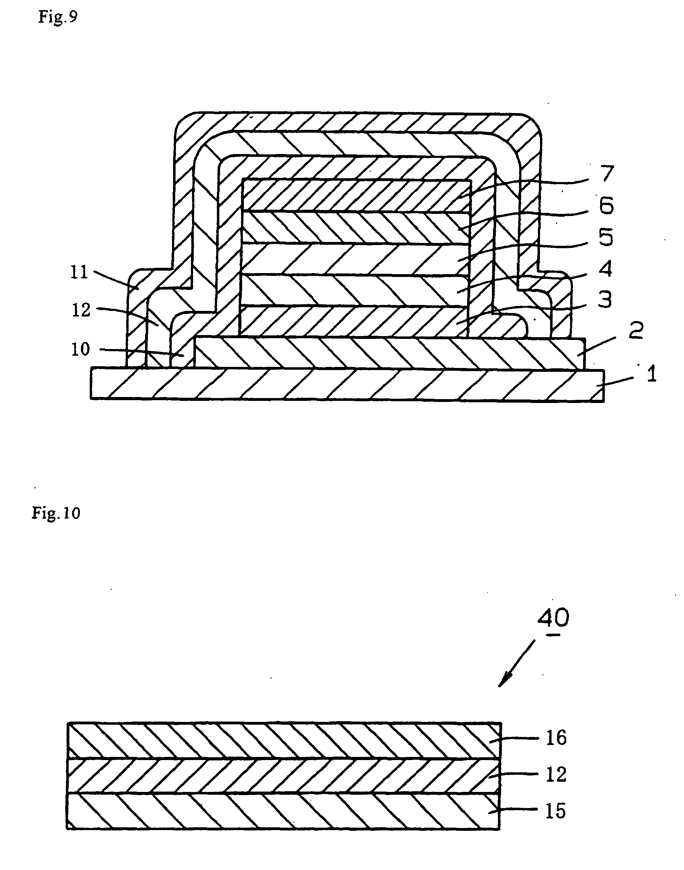

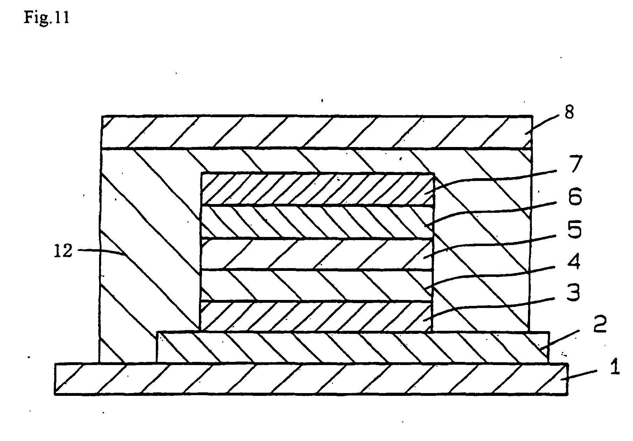

Fig. 1 is a sectional view showing schematically an example of a thin film structure. Fig. 2 is a sectional view showing schematically a cross section of an organic EL device sealed using an adhesive for sealing an organic EL device of the first present invention. Fig. 3 is a sectional view showing schematically a cross section of an organic EL device sealed using the adhesive for sealing an organic EL device of the first present invention. Fig. 4 is a sectional view showing schematically a cross section of an organic EL device sealed using the adhesive for sealing an organic EL device of the first present invention after forming a protective film comprising an inorganic material on the outside of the thin film structure. Fig. 5 is a sectional view showing schematically an example of an adhesive tape for sealing an organic EL device of the second present invention. Fig. 6 is a sectional view showing schematically the adhesive tape for sealing an organic EL device, having a drying agent in sheet form in an adhesive layer, of the second present invention. Fig. 7 is a sectional view showing schematically a cross section of an organic EL device sealed using the adhesive tape for sealing an organic EL device of the second present invention. Fig. 8 is a sectional view showing schematically a cross section of an organic EL device sealed using the adhesive tape for sealing an organic EL device, having a drying agent in sheet form, of the second present invention. Fig. 9 is a sectional view showing schematically a cross section of an organic EL device sealed using the adhesive tape for sealing an organic EL device of the second present invention after forming a protective film comprising an inorganic material on the outside of the thin film structure. Fig. 10 is a sectional view showing schematically an example of a double-faced adhesive tape for sealing an organic EL device of the third present invention. Fig. 11 is a sectional view showing schematically a cross section of an organic EL device sealed using the double-faced adhesive tape for sealing an organic EL device of the third present invention.

In drawings, a reference numeral 1 denotes a substrate, a numeral 2 denotes an anode, a numeral 3 a hole injection layer, a numeral 4 a hole transport layer, a numeral 5 an organic thin film (luminescence layer), a numeral 6 an electron injection layer, a numeral 7 a cathode, a numeral 8 a sealing plate, a numeral 9 an adhesive, a numeral 10 a protective film, a numeral 11 a moisture-proof tape, a numeral 12 an adhesive layer, a numeral 13 a release film, a numeral 14 a drying agent in sheet form, a numeral 15 a separator, a numeral 16 a separator, a numeral 20 a thin film structure, a numeral 30 an adhesive tape for sealing an organic EL device, a numeral 31 an adhesive tape for sealing an organic EL device, having a drying agent in sheet form, and a numeral 40 a double-faced adhesive tape for sealing an organic EL device.

### DETAILED DISCLOSURE OF THE INVENTION

Hereinafter, the present invention will be described in more detail.

An adhesive for sealing an organic electroluminescence device (hereinafter, also referred to as an adhesive for sealing an organic EL device) of the first present invention comprises a photo cationic polymerizable adhesive which initiates a curing reaction by light irradiation and proceeds the curing reaction by a dark reaction even after interrupting the light irradiation. Since the adhesive for sealing an organic EL device of the first present invention comprises such a photo cationic polymerizable adhesive, it is possible to seal an organic EL device, for example, by applying the adhesive for sealing an organic EL device of the first present invention to a sealing plate for sealing the organic EL device, irradiating the adhesive with light to activate the adhesive and the interrupting the light, and bonding the sealing plate and a thin film structure, and it is possible to seal the organic EL device without exposing the device to light or heat.

The adhesive for sealing an organic EL device of the first present invention preferably has a time, which is available before the adhesive becomes incapable of bonding due to proceeding of a curing reaction after irradiating light, of 1 minute or more. When this time is less than 1 minute, curing has proceeded before sealing a luminescence layer and therefore sufficient adhesion strength may not be attained.

The above-mentioned photo cationic polymerizable adhesive contains at least a photo cationic polymerizable compound and a photo cationic polymerization initiator.

The above-mentioned photo cationic polymerizable compound is not particularly limited as long as it is a compound containing at least one functional group which is photo cationic polymerizable in a molecule. As the above-mentioned photo cationic polymerizable functional group, there are given compounds containing functional groups such as an epoxy group, an oxetane group, a hydroxyl group, a vinyl ether group, an episulfide group, and an ethyleneimine group. Among others, there are suitably used epoxy group-containing compounds having at least one epoxy group in a molecule, which develop a high adhesive property and high durability after curing.

The above-mentioned epoxy group-containing compound is not particularly limited but aromatic epoxy resins are suitable. Among others, a phenoxy resin is more suitable.

The above-mentioned phenoxy resin is not particularly limited, but resin having a weight-average molecular weight of 50,000 to 100,000 and an epoxy equivalent of 7,000 to 10,000 is suitable. As a commercially available resin among such the phenoxy resins, there are given, for example, "Epicoat 1256", "Epicoat 4250", "Epicoat 4275" and "Epicoat 1255 HX30" (produced by Japan Epoxy Resins Co., Ltd.); and "YP-50S" (produced by Tohto Kasei Co., Ltd.).

As the above-mentioned aromatic epoxy resin other than the phenoxy resin, there are given, for example, TBBPA type resins such as one expressed by the following formula (2), trifunctional type resins such as one expressed by the following formula (3), biphenyl type resins, naphthalene type resins, phenol novolak type resins, cresol novolak type resins, dicyclopentadiene type resins and tetraphenylol ethane type resins.

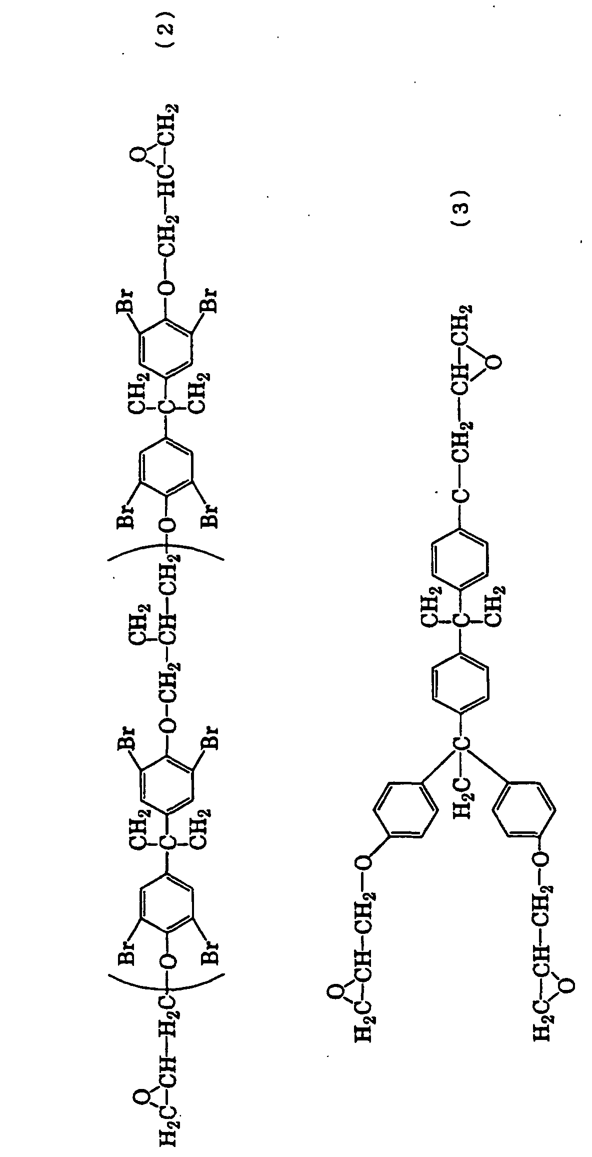

As another examples of the above epoxy group-containing compound, there are given addition polymers of an epoxy group-containing monomer and an epoxy group-containing oligomer, for example, epoxy group-containing resins such as epoxy group-containing polyester resin, epoxy group-containing polyurethane resin and epoxy group-containing acrylic resin. In this case, in order to provide moderate flexibility for the cured resin, flexible epoxy resin may be used.

These epoxy group-containing compound may be used alone or may be used in combination of two or more species.

The above-mentioned photo cationic polymerization initiator may be an ionic photo-acid producing type or may be a nonionic photo-acid producing type.

As a photo cationic polymerization initiator of above-mentioned ionic photo-acid producing type, there are given onium salts such as aromatic diazonium salt, aromatic halonium salt, aromatic sulfonium salt, etc.; and organic metal complexes such as an iron- allene complex, a titanocene complex, an arylsilanol-aluminum complex.

Among others, a photo cationic polymerization initiator comprising a salt containing voluminous boronic acid expressed by the following formula (1) as a counter ion is suitable because it is resistant to the occurrence of oxidation of an electrode at an interface between an electrode and an adhesive and has high durability.

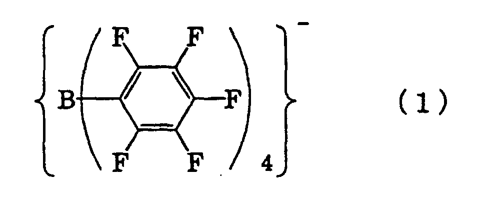

As a commercially available one among such a photo cationic polymerization initiator, there are given, for example, "PI-2074" (produced by Rhone-Poulenc) expressed by the following formula (4), "TAG-371R" (produced by TOYO INK MFG. CO.,LTD.) expressed by the following formula (5), and "TAG-372R" (produced by TOYO INK MFG. CO.,LTD.) expressed by the following formula (6).

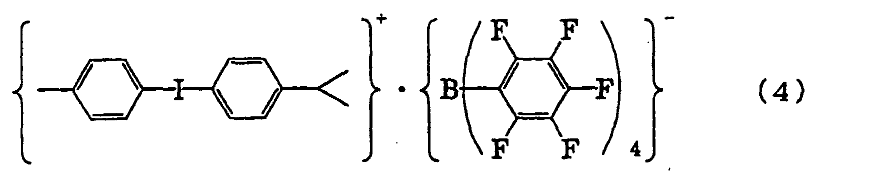

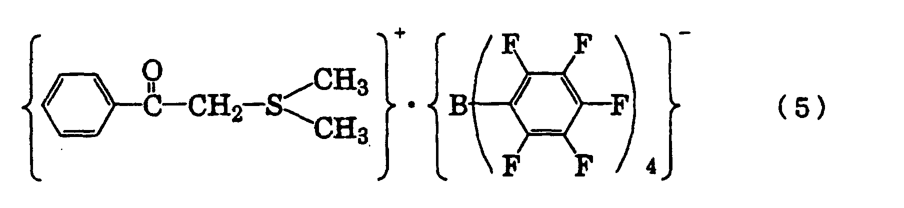

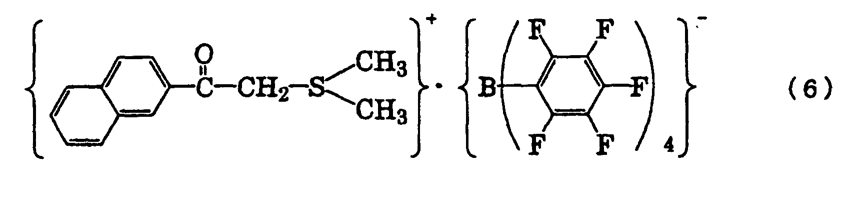

And, since a photo cationic polymerization initiator containing iodine can absorb light with a long wavelength, it is expected that a wavelength of polymerization initiation can be set on the long wavelength side, but this initiator may color the resulting polymer on one hand. In this case, it is preferred to use the photo cationic polymerization initiators expressed by the following formulas (7) to (9) since a wavelength of polymerization initiation can be set on the long wavelength side without coloring.

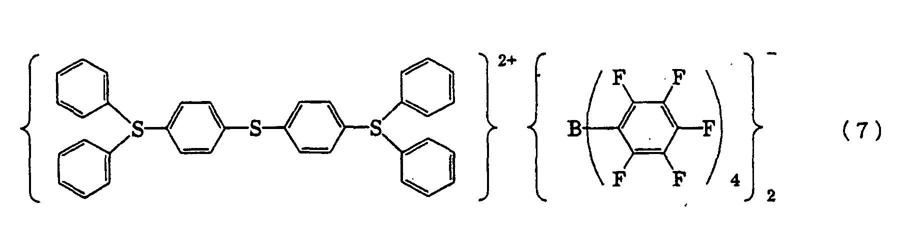

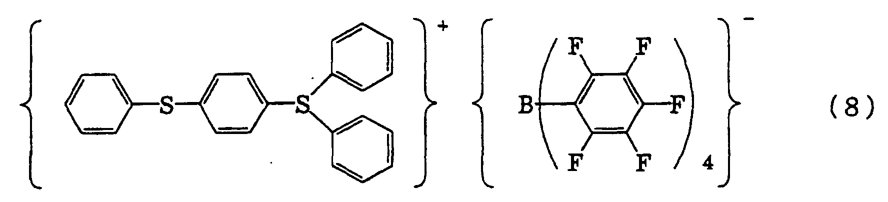

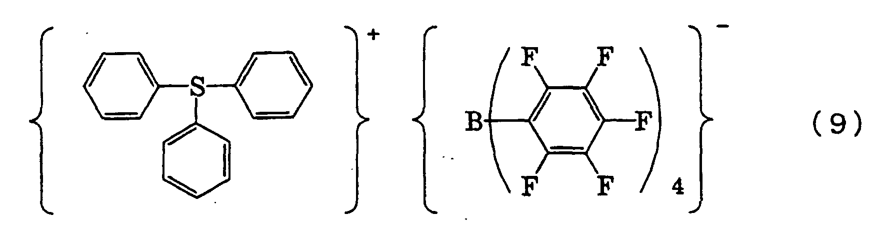

A photo cationic polymerization initiator of above-mentioned nonionic photo-acid producing type is not particularly limited, and includes, for example, nitrobenzil ester, sulfonic acid derivatives, phosphoric acid ester, phenolsulfonic acid ester, diazonaphthoquinone and N-hydroxyimide sphonate.

As the above photo cationic polymerization initiator, highly polymerized or multimerized one is preferably used. After the above photo cationic polymerization initiator produces acid and initiates cationic polymerization, the residual may become out gas and degrade the device. The present inventors studied deeply and have found that when the photo cationic polymerization initiator highly polymerized or multimerized is used, generation of the out gas can be inhibited.

A method of highly polymerizing or multimerizing the above-mentioned photo cationic polymerization initiator is not particularly limited and for example, a method of employing a reaction product of a compound containing at least one hydroxyl group in a molecule and producing an acid by light irradiation and a compound containing two or more functional group, which are reactive with a hydroxyl group, in a molecule, more preferably a reaction product of a compound containing two or more hydroxyl groups in a molecule and producing an acid by light irradiation and carboxylic anhydride or dicarboxylic acid, as a photo cationic polymerization initiator is suitable.

As a commercially available one among the above-mentioned compound having at least one hydroxyl group in a molecule and producing an acid by light irradiation, there are given, for example, "SI-80L" produced by SANSHIN CHEMICAL INDUSTRY CO., LTD. and "SP-170" produced by Asahi Denka Co., Ltd., which have a sulfonium salt skeleton, and"CD-1012" produced by Sartomer Company Inc., which has a iodonium salt skeleton.

And, as the above functional group, which are reactive with a hydroxyl group, in a molecule, there are give a carboxyl group, a isocyanate group, etc., and the above compound containing two or more functional group, which are reactive with a hydroxyl group, in a molecule is not particularly limited, but carboxylic anhydride or dicarboxylic acid is suitable. As the above-mentioned carboxylic anhydride, there can be given, for example, phthalic anhydride, maleic anhydride, etc., and as the above-mentioned dicarboxylic acid, there can be given aliphatic acids such as succinic acid, glutaric acid, adipic acid, etc.; and aromatic acids such as phthalic acid, terephthalic acid, isophthalic acid, etc.

These photo cationic polymerization initiators may be used alone or may be used in combination of two or more species.

The amount of the above photo cationic polymerization initiator to be blended in the above photo cationic polymerizable adhesive is not particularly limited, but it is preferably 0.1 to 10 parts by weight with respect to 100 parts by weight of the above photo cationic polymerization compound. When it is less than 0.1 parts by weight, photo cationic polymerization may not adequately proceed or a reaction may become too slow, and when it is more than 10 parts by weight, a reaction may become too fast, leading to deterioration of workability or ununiformity of reaction.

Preferably, the above-mentioned photo cationic polymerizable adhesive further contains aliphatic hydrocarbon having a hydroxyl group and/or a polyether compound. Since the above-mentioned aliphatic hydrocarbon having a hydroxyl group or polyether compound inhibits a photo cationic polymerization reaction of the above photo cationic polymerizable adhesive, by containing these compound in a proper amount, this adhesive play a role as a reaction modifier controlling an available time and a curing time after light irradiation, and this allows workability to substantially improve.

As the above-mentioned aliphatic hydrocarbon having a hydroxyl group, there are given polyfunctional hydroxyl group-containing compounds such as glycerin, pentaerythritol, and the like, and as the above-mentioned polyether compound, there are given polyalkylene oxides such as polyethylene glycol, polypropylene glycol, polyoxytetramethylene glycol, etc. Among others, polyalkylene oxides are suitably used and polyoxytetramethylene glycol is particularly suitably used.

An end of the above polyalkylene oxide is not particularly limited and it may be a hydroxyl group or may be etherified or esterified by another compound or may be a functional group such as an epoxy group. The hydroxyl group and the epoxy group are suitably used because they react with the above cationic polymerizable compound.

As the above-mentioned polyether compound, polyalkylene oxide addition bisphenol derivative is also suitably used, a compound having particularly a hydroxyl group or an epoxy group at its end is particularly suitably used. As a commercially available compound among them, there are given, for example, Rika Resin BPO-20E, Rika Resin BEO-60E, Rika Resin EO-20 and Rika Resin PO-20 (any produced by New Japan Chemical Co., Ltd.).

An amount of the above aliphatic hydrocarbon having a hydroxyl group and/or a polyether compound to be blended in the above photo cationic polymerizable adhesive is not particularly limited and it is appropriately determined depending on an available time and a curing time required and added, but generally, it is preferably 1 to 30 parts by weight with respect to 100 parts by weight of the above photo cationic polymerization compound, more preferably 5 to 20 parts by weight.

Preferably, the above photo cationic polymerizable adhesive further contains an alkaline filler being reactive with acid and/or an ion-exchange resin adsorbing an acid. When the above photo cationic polymerizable adhesive conducts photo cationic polymerization, an acid is produced and it may erode the electrode, but the durability of the above device electrode may be improved by containing the alkaline filler being reactive with acid and/or an ion-exchange resin adsorbing an acid. The above-mentioned alkaline filler being reactive with an acid is not particularly limited as long as it is a material which neutralizes an acid, and includes, for example, carbonate or hydrogencarbonate of alkaline metal or alkaline earth metal such as calcium carbonate, calcium hydrogencarbonate, sodium carbonate, sodium hydrogencarbonate, etc. As the above-mentioned ion-exchange resin adsorbing an acid, any of a cation exchange type, an anion exchange type, and an amphoteric ion-exchange type can be used, but it is preferred to use particularly a cation exchange type and an amphoteric ion-exchange type, which can adsorb a chloride ion.

Preferably, the above photo cationic polymerizable adhesive further contains a filler. The water vapor transmission, the adhesion strength, the shrinkage due to curing and the coefficient of thermal expansion can be improved by containing a filler. The above-mentioned filler is not particularly limited, and includes for example, powders of colloidal silica, talc, mica, calcium carbonate, titanium oxide, clay, etc.; inorganic hollow bodies such as a glass balloon, an alumina balloon, a ceramic balloon, etc.; organic spheres such a nylon bead, an acrylic bead, a silicon bead, a fluororesin bead, etc.; organic hollow bodies such as a vinylidene chloride balloon, an acrylic balloon, etc.; monofilament of glass, polyester, rayon, nylon, cellulose, etc.

However, when the device is sealed in a manner of covering the surface of the thin film structure using the adhesive for sealing an organic EL device of the first present invention, since it is necessary that the adhesive has high transparency, the above-mentioned filler is preferably transparent and the amount of the filler blended is preferably restricted to minimum requirements. Since the adhesive for sealing an organic EL device of the first present invention proceeds a reaction by a dark reaction even after light irradiation and in addition can be designed so as to proceed a reaction slowly over at least several hours, it is also possible to seal surely even if the filler is not contained if a method, in which the adhesive is partially cured by irradiating light in advance and then the organic EL device is sealed with this adhesive, is employed.

Preferably, the above photo cationic polymerizable adhesive further contains a drying agent. The above-mentioned drying agent is not particularly limited and includes, for example, silica gel, molecular sieve, and oxides of alkaline earth metal such as calcium oxide, barium oxide, strontium oxide and the like.

When the above photo cationic polymerizable adhesive is used as an adhesive layer of an adhesive tape described below, it is preferred that the above photo cationic polymerizable adhesive further contains adhesive resin. The above-mentioned adhesive resin is not particularly limited as long as it can impart the adhesion and the sheet cohesion at room temperature to the adhesive layer, and includes, for example, epoxy resin, acrylic polymer, polyesters, polyurethanes, silicones, polyethers, polycarbonates, polyvinyl ethers, polyvinyl chlorides, and polyvinyl acetates, polyisobutylenes. And, the above adhesive resin may be a copolymer containing a monomer which will be a main component of these resins. Among others, acrylic resin or polyester resin is suitable since this resin develops an excellent initial adhesion and control of adhesive physical properties is easy.

The above photo cationic polymerizable adhesive may further contain a variety of additives such as an adhesion improver, a reinforcement, a softening agent, a plasticizer, a viscosity modifier or the like as required.

A method of producing the adhesive for sealing an organic EL device of the first present invention is not particularly limited and a method of mixing a photo cationic polymerizable compound, a photo cationic polymerization initiator and another compound in a predetermined amount at ordinary temperature or under heating using a mixer such a homo disper, a homo mixer, a universal mixer, a planetary mixer, a kneader and a roll mill is given. In addition, the production of the adhesive is preferably carried out in a state of interrupting light.

Since the adhesive for sealing an organic EL device of the first present invention initiates a curing reaction by light irradiation and proceeds the curing reaction by a dark reaction even after interrupting the light irradiation, it can seal the organic EL device without exposing the device to light or heat when the adhesive is activated by being irradiated with light once and used before the adhesive is completely cured. Further, it can seal the organic EL device with reliability even when there is a part to which light is not irradiated due to a metal wire or even when a substrate containing an ultraviolet absorber is sealed. The adhesive for sealing an organic EL device of the first present invention can also be suitably used for sealing a polarizing plate of a liquid crystal panel in addition to sealing the organic EL device. A wavelength of the above light is not particularly limited as long as it is a wavelength at which the above photo cationic polymerization initiator can initiate the polymerization or curing of the photo cationic polymerizable compound and it is appropriately selected in response to a photosensitive wavelength of the above photo cationic polymerization initiator. Further, the amount of irradiation of the above light is not particularly limited and it is appropriately determined depending on species and amount of the above photo cationic polymerization initiator. A light source of irradiation irradiating the light of such a wavelength and amount of irradiation is not particularly limited and includes, for example, a fluorescent lamp, a high-pressure mercury lamp, and a xenon lamp. In addition, after the adhesive for sealing an organic EL device of the first present invention is cured by being irradiated with light, curing of the adhesive may be further promoted by being heated as required.

A method of sealing an organic EL device using the adhesive for sealing an organic EL device of the first present invention is not particularly limited. As such a method, there are given, for example, (1) a method in which after irradiating light to the adhesive for sealing an organic EL device of the first present invention, the device is sealed by filling the space between a sealing plate and a thin film structure with the adhesive for sealing an organic EL device before the adhesive for sealing an organic EL device is cured; and (2) a method in which after irradiating light to the adhesive for sealing an organic EL device of the first present invention, the device is sealed by applying the adhesive for sealing an organic electroluminescence device so as to seal the periphery of the thin film structure and bonding the sealing plate to the applied adhesive before the adhesive for sealing an organic electroluminescence device is cured. These methods of sealing the an organic EL device also constitute the present invention.

The above-mentioned sealing plate is not particularly limited as long as it can plays a role to prevent the entry of water content from the outside, and for example, a glass plate, a protective film comprising an inorganic material or the like, is suitable. The above-mentioned protective film comprising an inorganic material is not particularly limited, and for example SiₓN_{y}O₂, Al₂O₃, and DLC (diamond-like carbon) are given.

Though it is possible to practice the method of sealing an organic EL device of the present invention at normal temperature and pressure, it is preferred to do it in a space where water content is controlled. The reason for this is that the entry of water content during sealing the thin film structure is surely prevented.

When the thin film structure is covered with the adhesive for sealing an organic EL device of the first present invention, it is preferred to cover the entire thin film structure with the adhesive, but it is not necessarily required to cover the entire thin film structure with an adhesive. At least a part, in which the organic EL device is affected by moisture or oxygen or oxidized through contact with outside air to degrade its luminescent property, of materials constituting the thin film structure may be covered with an adhesive. Therefore, a part (near outer edge and side portion) of an anode of the thin film structure does not require to be covered.

In Fig. 2 and 3, there are shown sectional views showing schematically cross sections of an organic EL device sealed using the adhesive for sealing an organic EL device of the first present invention. In the organic EL device shown in Fig. 2 and 3, lead terminals of the anode 2 and the cathode 7 of the thin film structure 20 are not covered with the adhesive for sealing an organic EL device and guided to the vicinity of an outer edge of the substrate 1.

And, when the organic EL device is sealed, it is preferred that the device is sealed with the adhesive for sealing an organic EL device of the first present invention after forming a protective film comprising an inorganic material on the outside of the thin film structure. The above-mentioned protective film comprising an inorganic material is not particularly limited, and for example SiₓN_{y}O_{z}, Al₂O₃, and DLC (diamond-like carbon) are given. A method of forming the above protective film comprising an inorganic material is not particularly limited, and the protective film can be formed by, for example, plasma CVD (chemical vapor deposition) method, a sputtering process, a vacuum evaporation method, etc. Further, the protective film may be formed on a film such as polyimide and polyparaxylylene and the resulting film may be laminated on the thin film structure. In Figure 4, there is shown a sectional view showing schematically a cross section of an organic EL device sealed using the adhesive for sealing an organic EL device of the first present invention after forming a protective film comprising an inorganic material on the outside of the thin film structure.

The adhesive for sealing an organic EL device of the first present invention may be used as-is as'an adhesive to seal the devices as described above, but it can seal the devices more efficiently by being processed into the form of tape to be used. The second present invention pertains to an adhesive tape for sealing an organic electroluminescence device (hereinafter, also referred to as an adhesive tape for sealing an organic EL device), which has a moisture-proof tape and an adhesive layer comprising the adhesive for sealing an organic electroluminescence device of the first present invention formed on at least one side of the moisture-proof tape.

In Fig. 5, there is shown a sectional view showing schematically an example of the adhesive tape for sealing an organic EL device of the second present invention. The adhesive tape 30 for sealing an organic EL device of the second present invention shown in Fig. 5 is constituted of the moisture-proof tape 11 and the adhesive layer 12. In addition, Fig. 5 shows the adhesive tape for sealing an organic EL device, not yet used for covering the outer surface of the thin film structure, and the moisture-proof film 11 is formed on the one side of the adhesive layer 12 and a release film 13 is formed on the opposite side.

The above-mentioned moisture-proof tape plays a role to prevent the entry of water content from the outside and preferably has the water vapor transmission rate, measure at 50°C and 90% relative humidity (RH), of 0.5 g/(m²·24h)/100 µm or less. The above moisture-proof tape may be a single layer comprising one kind of tape of low water vapor transmission rate or may be a laminate comprising two or more kinds of tapes of low water vapor transmission rate. When the above moisture-proof tape is a laminate, it is preferred to have a layer comprising of a hygroscopic tape or a tape coated with a water-absorbing agent in addition to a layer comprising a tape of low water vapor transmission rate. And, in order to improve the moisture resistance, a substance prepared by forming a thin film comprising aluminum, aluminum oxide, silicon oxide, silicon nitride or the like by vapor deposition as the above tape of low water vapor transmission rate may be used. Further, as the moisture-proof film, for example, a substance formed by laminating resin such as polypropylene or polyethylene terephthalate on an aluminum foil may be used.

As the above tape of low water vapor transmission rate, there are given tapes comprising polyfluoroethylene-based polymer such as polyethylene trifluoride, polychlorotrifluoroethylene (PCTFE), polyvinylidene fluoride (PVDF), a copolymer of PVDF and PCTFE and a copolymer of PVDF and polychlorofluoroethylene; cycloolefinic resins such as polyimide, polycarbonate and dicyclopentadiene, polyesters such as polyethylene terephthalate, polyethylene and polystyrene.

As the above-mentioned hygroscopic film, there are given, for example, films comprising highly water-absorption polymer such as polyamide polymer like nylon 6 and nylon 66, a copolymer of vinyl alcohol and acrylic acid, a polyethylene oxide polymer, a copolymer of acrylic acid and starch, and a copolymer of starch and acrylonitrile.

As the above-mentioned water-absorbing agent, there are given, for example, silica gel, molecular sieve, and oxides of alkaline earth metal such as calcium oxide, barium oxide, strontium oxide and the like.

The above moisture-proof tape has preferably a thickness of 10 to 1,000 µm, and more preferably a thickness of 20 to 300 µm.

The above-mentioned release film is formed for the purpose of protecting the surface of the adhesive layer and will be peeled off in sealing. The above release film is not particularly limited as long as it has a releasing property, and includes, for example, a substance formed by coating the surface of base material comprising paper, polyester such as polyethylene terephthalate (PET) and the like, and aluminum foil with a mold release agent comprising silicon-based material.

In the adhesive tape for sealing an organic EL device of the second present invention, the adhesive layer comprising the adhesive for sealing an organic EL device of the first present invention is formed on the above moisture-proof tape. The above-mentioned adhesive layer may be formed on the entire surface of the above moisture-proof tape so as to cover the entire outside of the thin film structure to be sealed or may be partially formed in the form of surrounding the thin film structure to be sealed on the surface of the moisture-proof tape. When the above adhesive layer is partially formed, it is preferred that the adhesive layer is formed so as to surround the entire thin film structure to be sealed, but it may be formed so as to surround at least a part, in which the organic EL device is affected by moisture or oxygen or oxidized through contact with outside air to degrade its luminescent property, of materials constituting the thin film structure.

Preferably, the above adhesive layer has the water vapor transmission rate, measure by a dish method based on JIS Z 0208 under the conditions of 60°C and 90% relative humidity (RH), of 30 g/(m²•24h)/100 µm or less. When the water vapor transmission rate is more than 30 g/(m²•24h)/100 µm, the intrusion of oxygen or water cannot be adequately prevented and this may cause the degradation of the thin film structure comprising an electron injection electrode, an organic thin film and a hole injection electrode provided on the substrate constituting the organic EL device.

Preferably, the adhesive tape for sealing an organic EL device of the second present invention has a drying agent in sheet form in the above adhesive layer. The above drying agent in sheet form absorbs water content in the adhesive layer and prevents the water from transferring to the thin film structure. As the above drying agent in sheet form, there are given, for example, a substance formed by covering a publicly known drying agent such as silica gel, molecular sieve, calcium oxide, barium oxide, strontium oxide or the like with porous fluorine-based resin film, porous olefin resin or the like, in which water-permeable pores are formed; a porous film containing a drying agent; and a substance formed by containing a drying agent in a non-porous moisture-permeable film. When the drying agent is covered with fluorine-based resin film or olefin resin like this, the drying agent does not contact directly with the adhesive material or the thin film structure and does not degrade the organic EL device and a water absorptive effect of the drying agent can be maintained.

Preferably, the above drying agent in sheet form has a size of the order of being capable of covering the thin film structure to be sealed and in addition it is placed at minimum distance from the thin film structure and is placed on the release film-side of the adhesive layer.

In Fig. 6, there is shown a sectional view showing schematically the adhesive tape for sealing an organic EL device, having a drying agent in sheet form in an adhesive layer, of the second present invention. The adhesive tape 31 for sealing an organic EL device of the second present invention shown in Fig. 6 is constituted of the moisture-proof tape 11 and the adhesive layer 12 and the drying agent 14 in sheet form is placed in the adhesive layer 12. In addition, Fig. 6 shows the state of the adhesive tape, not yet used for covering the outer surface of the thin film structure, and the moisture-proof tape 11 is formed on the one side of the adhesive layer 12 and the release film 13 is laminated on the opposite side.

A method of producing the adhesive tape for sealing an organic EL device of the second present invention is not particularly limited and includes, for example, a method of applying the adhesive for sealing an organic electroluminescence device of the first present invention to the surface of the above moisture-proof tape by a publicly known coating method such as a hot melt coating process or a cast coating process.

In accordance with the adhesive tape for sealing an organic EL device of the second present invention, the thin film structure can be sealed by irradiating light only to the adhesive layer of the tape since the adhesive for sealing an organic EL device of the first present invention is used in the adhesive layer. Therefore, since the thin film structure is not irradiated directly with light and the contact of the thin film structure with gas generated in curing of the adhesive layer can be avoided, it is possible to seal the thin film structure easily without impairing the device. Further, since the above adhesive layer has a low water vapor transmission rate, an organic EL device, which is sealed using the adhesive tape for sealing an organic EL device of the second present invention, doesn't cause degradation by the intrusion of oxygen or water and can have a prolonged life. The adhesive tape for sealing an organic EL device of the second present invention can be suitably used for sealing a polarizing plate of a liquid crystal panel in addition to sealing the organic EL device.

A method of sealing the organic EL device using the adhesive tape for sealing an organic EL device of the second present invention is not particularly limited, but for example a method, in which after irradiating light to the adhesive layer of the adhesive tape for sealing an organic electroluminescence device, the device is sealed by bonding the adhesive tape onto the thin film structure before the adhesive layer is cured, is suitable. Such a method of sealing the organic EL device also constitutes the present invention.

Though it is possible to practice the method of sealing an organic EL device of the present invention at normal temperature and pressure, it is preferred to do it in a space where a moisture content is controlled. The reason for this is that the entry of water content during sealing the thin film structure is surely prevented.

And, when the thin film structure is covered with the adhesive tape for sealing an organic EL device of the second present invention, it is preferred to cover the entire thin film structure with the tape, but it is not necessarily required to cover the entire thin film structure with the tape. At least a part, in which the organic EL device is affected by moisture or oxygen or oxidized through contact with outside air to degrade its luminescent property, of materials constituting the thin film structure may be covered with the tape. Therefore, a part (near outer edge and side portion) of an anode of the thin film structure does not require to be covered.

In Fig. 7, there is shown a sectional view showing schematically a cross section of the organic EL device sealed using the adhesive tape for sealing an organic EL device of the second present invention. In the organic EL device shown inn Fig. 7, lead terminals of the anode 2 and the cathode 7 of the thin film structure 20 are not covered with the adhesive tape for sealing an organic EL device and guided to the vicinity of an outer edge of the substrate 1.

And, in Fig. 8, there is shown a sectional view showing schematically a cross section of the organic EL device sealed using the adhesive tape for sealing an organic EL device, having the above drying agent in sheet form, of the second present invention.

And, when the organic EL device is sealed, it is preferred that the device is sealed with the adhesive tape for sealing an organic EL device of the second present invention after forming a protective film comprising an inorganic material on the outside of the thin film structure. The above-mentioned protective film comprising an inorganic material is not particularly limited, and for example SiₓN_{y}O_{z}, Al₂O₃, and DLC (diamond-like carbon) are given. A method of forming the above protective film comprising an inorganic material is not particularly limited, and the protective film can be formed by, for example, plasma CVD (chemical vapor deposition) method, a sputtering process, a vacuum evaporation method, etc. Further, the protective film may be formed on a film such as polyimide and polyparaxylylene and the resulting film may be laminated on the thin film structure. In Fig. 9, there is shown a sectional view showing schematically a cross section of an organic EL device sealed using the adhesive tape for sealing an organic EL device of the second present invention after forming a protective film comprising an inorganic material on the outside of the thin film structure.

The third present invention pertains to a double-faced adhesive tape for sealing an organic electroluminescence device (hereinafter, also referred to as a double-faced adhesive tape for sealing an organic EL device), which has an adhesive layer comprising the adhesive for sealing an organic electroluminescence device of the first present invention and separators formed on both sides of the adhesive layer.

In Fig. 10, there is shown a sectional view showing schematically an example of the double-faced adhesive tape for sealing an organic EL device of the third present invention. In the double-faced adhesive tape 40 for sealing an organic EL device shown in Fig. 10, separators 15, 16 are formed on both sides of the adhesive layer 12.

The above-mentioned separators act as a protective film or a supporting member of the adhesive layer. The above separator is not particularly limited as long as it is made of a film having a releasing property, and includes, for example, a substance formed by coating the surface of base material comprising paper, polyester such as polyethylene terephthalate (PET) and the like, and aluminum foil with a release agent comprising silicone-based material.

Further, it is preferred that the above separators to be formed on both sides of the adhesive layer have different degrees of ease of peeling from the adhesive layer. When irradiating light to the adhesive layer, it is necessary to peel off one separator precedently, and if the two separators do not have different degrees of ease of peeling, there is a possibility that it becomes impossible to peel off only one separator.

The above-mentioned adhesive layer comprises the adhesive for sealing an organic electroluminescence device of the first present invention. The above adhesive layer may be formed on the entire surface of the above separator so as to cover the entire outside of the thin film structure to be sealed or may be partially formed in the form of surrounding the thin film structure to be sealed on the surface of the separator. When the above adhesive layer is partially formed, it is preferred that the adhesive layer is formed so as to surround the entire thin film structure to be sealed, but it may be formed so as to surround at least a part, in which the organic EL device is affected by moisture or oxygen or oxidized through contact with outside air to degrade its luminescent property, of materials constituting the thin film structure.

A thickness of the above adhesive layer is appropriately adjusted in consideration of the constitution of the adhesive for sealing an organic electroluminescence device of the first present invention and the setting of available time responsive to the uses, but it is preferably 1 to 1,000 µm. Preferably, the above adhesive layer has the water vapor transmission rate, measure by a dish method based on JIS Z 0208 under the conditions of 60°C and 90% relative humidity (RH), of 30 g/(m²·24h)/100 µm or less. When the water vapor transmission rate is more than 30 g/ (m2•24h) /100 µm, the thin film structure, which comprises an electron injection electrode, an organic thin film and a hole injection electrode provided on the substrate constituting the organic EL device, may be degraded by the intrusion of oxygen or water.

A method of producing the double-faced adhesive tape for sealing an organic electroluminescence device of the third present invention is not particularly limited and includes, for example, a method of applying the adhesive for sealing an organic electroluminescence device of the first present invention to the surface of one separator by a publicly known coating method such as a hot melt coating process or a cast coating process and then laminating the other separator.

The double-faced adhesive tape for sealing an organic EL device of the third present invention can seal the thin film structure by irradiating light only to the adhesive layer of the tape since the adhesive for sealing an organic EL device of the first present invention is used in the adhesive layer. Therefore, since the thin film structure is not irradiated directly with light and the contact of the thin film structure with gas generated in curing of the adhesive layer can be avoided, it is possible to seal the thin film structure easily without impairing the device. Further, since the above adhesive layer has a low water vapor transmission rate, an organic EL device, which is sealed using the double-faced adhesive tape for sealing an organic EL device of the third present invention, doesn't cause degradation by the intrusion of oxygen or water and can have a prolonged life. The double-faced adhesive tape for sealing an organic EL device of the third present invention can also be suitably used for sealing a polarizing plate of a liquid crystal panel in addition to sealing the organic EL device.

A method of sealing an organic EL device using the double-faced adhesive tape for sealing an organic EL device of the third present invention is not particularly limited and for example, a method, in which after peeling off one separator of the double-faced adhesive tape for sealing an organic electroluminescence device of the third present invention and irradiating light to the adhesive layer on the side on which the separator has been peeled off, the device is sealed by bonding the double-faced adhesive tape for sealing an organic electroluminescence device so as to seal the periphery of the thin film structure and peeling off the other separator of the double-faced adhesive tape and further coating the adhesive layer with a sealing plate before the adhesive layer is cured, is suitable. Such a method of sealing the organic electroluminescence device also constitutes the present invention.

The above-mentioned sealing plate is not particularly limited as long as it can plays a role to prevent the entry of water content from the outside, and for example, a glass plate, a protective film comprising an inorganic material or the like, is suitable. The above-mentioned protective film comprising an inorganic material is not particularly limited, and for example SiₓN_{y}O_{z}, Al₂O₃, and DLC (diamond-like carbon) are given.

Though it is possible to practice the method of sealing an organic EL device of the present invention at normal temperature and pressure, it is preferred to do it in a space where water content is controlled. The reason for this is that the entry of water content during sealing the thin film structure is surely prevented.

And, when the thin film structure is covered with the double-faced adhesive tape for sealing an organic EL device of the third present invention, it is preferred to cover the entire thin film structure with the tape, but it is not necessarily required to cover the entire thin film structure with the tape. At least a part, in which the organic EL device is affected by moisture or oxygen or oxidized through contact with outside air to degrade its luminescent property, of materials constituting the thin film structure may be covered with the tape. Therefore, part (near outer edge and side portion) of an anode of the thin film structure does not require to be covered.

In Fig. 11, there is shown a sectional view showing schematically a cross section of the organic EL device sealed using the double-faced adhesive tape for sealing an organic EL device of the third present invention. In the organic EL device shown in Fig. 11, lead terminals of the anode 2 and the cathode 7 of the thin film structure 20 are not covered with the double-faced adhesive tape for sealing an organic EL device and guided to the vicinity of an outer edge of the substrate 1. And, when the organic EL device is sealed, it is preferred that the device is sealed with the double-faced adhesive tape for sealing an organic EL device of the third present invention after forming a protective film comprising an inorganic material on the outside of the thin film structure. The above-mentioned protective film comprising of an inorganic material is not particularly limited, and for example SiₓN_{y}O_{z}, Al₂O₃, and DLC (diamond-like carbon) are given. A method of forming the above protective film comprising an inorganic material is not particularly limited, and the protective film can be formed by, for example, plasma CVD (chemical vapor deposition), a sputtering process, a vacuum evaporation method, etc. Further, the protective film may be formed on a film such as polyimide and polyparaxylylene and the resulting film may be laminated on the thin film structure.

An organic electroluminescence device, which is sealed by using the adhesive for sealing an organic electroluminescence device of the first present invention, the adhesive tape for sealing an organic electroluminescence device of the second present invention, or the double-faced adhesive tape for sealing an organic electroluminescence device of the third present invention, also constitutes the present invention.

Further, the adhesive for sealing an organic electroluminescence device of the present invention can also be utilized as an adhesive for securing a polarizing plate to a liquid crystal panel.

### BEST MODE FOR CARRYING OUT THE INVENTION

Hereinafter, the present invention will be described in more detail by way of examples, but the present invention is not limited to these examples.

### (Examples 1 to 3 and Comparative Examples 1 to 2)

### (1) Fabrication of organic EL device substrate 1

Substances, which were fabricated by forming a film of indium tin oxide (ITO) electrode in a thickness 1,000 Å on a glass substrate (25 mm × 25 mm × 0.7 mm), were used as a transparent supporting substrate. After each of the above-mentioned transparent supporting substrates was ultrasonically cleaned for 15 minutes with acetone, an alkaline aqueous solution, ion-exchanged water and isopropyl alcohol, respectively, it was cleaned for 10 minutes with boiled isopropyl alcohol and further treated at the last minute with UV-Ozone Cleaner (NL-UV 253, manufactured by Nippon Laser & Electronics LAB.). Next, this transparent supporting substrate was secured to a substrate holder of a vacuum evaporation apparatus, and 200 mg of N,N'-di(1-naphthyl)- N,N'-diphenylbenzidine (α-NPD) was put in a biscuit crucible and 200 mg of tris(8-hydroxyquinoline)aluminum (Alq3) was put in another biscuit crucible, and the inside pressure of a vacuum chamber was reduced to 1 × 10⁻⁴ Pa. Then, the α-NPD-charged crucible was heated and α-NPD was deposited on the substrate at a vapor deposition rate of 15 Å/s to form a film of a hole transport layer having a film thickness of 600 Å. And so, the crucible of Alq3 was heated and a luminescence layer having a film thickness of 600 Å was formed at a vapor deposition rate of 15 Å/s. After this, the transparent supporting substrates was transferred to another vacuum evaporation apparatus and 200 mg of lithium fluoride was put in a resistive heating boat made of tungsten in this vacuum evaporation apparatus and 1.0 g of aluminum wire was put in another tungsten boat. Then, the inside pressure of a vacuum cell was reduced to 2 × 10⁻⁴ Pa, and a film of lithium fluoride was formed at a vapor deposition rate of 0.2 Å/s in a film thickness of 5 Å, and then a film of aluminum was formed at a vapor deposition rate of 20 Å/s in a film thickness of 1,000 Å. Inside of a vacuum evaporation apparatus was returned to a normal pressure by nitrogen flow and the transparent supporting substrates was taken out to obtain an organic EL device substrate 1 fabricated on the transparent supporting substrate.

### (2) Preparation of adhesive

According to the composition shown in Table 1, respective materials are homogeneously stirred and mixed at a stirring speed of 3,000 rpm using a HOMO DISPER type stirring mixer (HOMO DISPER L TYPE manufactured by Tokushu Kika Kogyo Co., Ltd.) to prepare a photo cationic polymerizable adhesive and this was used as an adhesive for sealing an organic EL device.

### (3) Sealing of devices

The obtained adhesive for sealing an organic EL device was applied to a glass backboard with a dispenser, and ultraviolet light with a wavelength of 365 nm was irradiated to the adhesive in such a way that the amount of irradiation is 2400 mJ/cm² using a high-pressure mercury lamp. Then, after bonding the organic EL device substrate and the glass backboard to which the adhesive for sealing an organic EL device was applied in a glove box in which nitrogen gas was flown through, this bonded substance was left standing for 10 minutes to cure the adhesive and to seal the organic EL device. In addition, in Example 3, the bonded substance was heated at 60°C for 5 minutes after bonding to cure the adhesive.

### (4) Evaluation

The evaluation of curability, curing time and cell evaluation was conducted according to the following method. The results are shown in Table 1.

### (Curability and curing time)

The sealed organic EL devices were tested every 5 minutes as to whether the device substrate and the back board can slide past each other by hand after irradiation, and the curability was evaluated according to the following criteria and a time when the device substrate and the back board cease to slide is taken as a curing time.
- ○ :: They do not slide at all
- × :: Adhesive is soft and they slide

### (Cell evaluation)

After the sealed organic EL device was exposed to the conditions of 60°C and 90% relative humidity for 100 hours, voltage of 10 V was applied to the device and a luminous state (light emission and the presence dark spots and dark lines) of the device was visually observed and evaluation was conducted according to the following criteria. Incidentally, since in the cell in Comparative Example 1, the adhesive did not cure, the cell evaluation was not conducted.
- ○:: There is no dark spot and uniform light emission
- Δ :: Cell is luminous but there are dark spots and dark lines
- × :: They do not emit light at all

**Table 1**

| | | | Example 1 | Example 2 | Example 3 | Comparative Example 1 | Comparative Example 2 |
|---|---|---|---|---|---|---|---|
| Adhesion composition (parts by weight) | Photo cationic polymerizable compound | bisphenol-A type epoxy resin(Epicoat 828) | 50 | 50 | 50 | 50 | 50 |
| | | bisphenol-F type epoxy resin(Epicoat 4004) | 30 | 30 | 30 | 30 | 30 |
| | Photo cationic polymerization initiator | ADEKA OPTOMER SP-170 | 1 | 1 | 1 | 1 | 1 |
| | Reaction modifier | polytetramethylene glycol (PTMG 1000) | 10 | - | 10 | 10 | 10 |
| | | propylene glycol addition bisphenol-A type epoxy resin (Rika Resin BPO-20E) | - | 10 | - | - | - |
| | Filler | silica (Aerosil 2000) | 10 | 10 | 10 | 10 | 10 |
| Conditions of curing | | irradiation timing | irradiation | before | fabrication | irradiation after fabrication | |
| | | amount of irradiation (mJ/cm²) | 2400 | 2400 | 2400 | 2400 | 4800 |
| | | post-heating (60°C and 5 minutes) | none | none | applicable | - | - |
| Evaluation | Evaluation of | curability | ○ | ○ | ○ | × | ○ |
| | curability | curing time (minute) | 20 | 20 | 10 | - | - |
| | Cell evaluation | | ○ | ○ | ○ | - | × |

### (Examples 4 to 9 and Comparative Example 3)

### (1) Fabrication of organic EL device substrate 2

After glass substrates (25 mm × 25 mm × 0.7 mm) were cleaned by the same manner as in Examples 1, a film of aluminum electrode was formed in a thickness 1,000 Å on each glass substrate to obtain a transparent supporting substrate. Next, this transparent supporting substrates was secured to a substrate holder of a vacuum evaporation apparatus, 200 mg of α-NPD was put in a first biscuit crucible, 200 mg of Alq3 was put in a second biscuit crucible and 200 mg of lithium fluoride was put in a resistive heating boat made of tungsten, and the inside pressure of a vacuum chamber was reduced to 1 × 10⁻⁴ Pa. After this, a film of lithium fluoride was formed at a vapor deposition rate of 0.2 Å/s in a film thickness of 5 Å, and then a film of Alq3 was formed at a vapor deposition rate of 15 Å/s to form a luminescence layer having a film thickness of 600 Å. Next, α-NPD was deposited on the substrate at a vapor deposition rate of 15 Å/s to form a film of a hole transport layer having a film thickness of 600 Å. After this, the transparent supporting substrate was transferred to a sputtering apparatus provided with a target of indium tin oxide (ITO) and the inside pressure of a vacuum cell was reduced to 2 × 10⁻⁴ Pa, and then argon gas was introduced into the vacuum cell so as to be 0.4 Pa. A film of ITO was formed at a vapor deposition rate of 20 Å/s in a film thickness of 1,000 Å to provide a transparent electrode. Further, the processed transparent supporting substrate was transferred to a sputtering apparatus provided with a target of silicon oxide and the inside pressure of the vacuum cell was reduced to 2 × 10⁻⁴ Pa, and then argon gas was introduced into the vacuum cell so as to be 0.4 Pa. A film of silicon oxide was formed at a vapor deposition rate of 20 Å/s in a film thickness of 1,000 Å to provide a protective layer of the device. Inside of a vacuum evaporation apparatus was returned to a normal pressure by nitrogen flow and the transparent supporting substrates was taken out to obtain an organic EL device substrate 2 of upper side luminous type fabricated on the transparent supporting substrate.

### (2) Preparation of adhesive

According to the composition shown in Tables 2 and 3, respective materials are homogeneously stirred and mixed at a stirring speed of 3,000 rpm using a HOMO DISPER type stirring mixer (HOMO DISPER L TYPE manufactured by Tokushu Kika Kogyo Co., Ltd.) to prepare a photo cationic polymerizable adhesive and this was used as an adhesive for sealing an organic EL device.

### (3) Sealing of device

The obtained adhesive for sealing an organic EL device was applied to the entire surface of a glass backboard in a thickness of 50 µm with a coating apparatus, and ultraviolet light with a wavelength of 365 nm was irradiated to the adhesive in such a way that the amount of irradiation is 2400 mJ/cm² using a high-pressure mercury lamp. Then, after bonding the organic EL device substrate and the glass backboard to which the adhesive for sealing an organic EL device was applied in a vacuum, this bonded substance was left standing for 10 minutes to cure the adhesive and to seal the organic EL device.

### (4) Evaluation

The evaluation of curability, curing time and cell was conducted by the same procedure as in Example 1 and further an electrode durability test was conducted according to the following method. The results are shown in Table 2 and Table 3.

### (Electrode durability test)

An adhesive for sealing an organic EL device was applied to a glass plate provided with an aluminum electrode, and after light was irradiated to the adhesive, a glass plate on which an ITO electrode was formed was overlaid on the adhesive to cure the adhesive in a fixed state. After this, a set of the glass plates was left standing at 60°C with voltage of 10 V applied and change in a surficial condition of the aluminum electrode was visually observed.

**Table 2**

| | | | Example 4 | Example 5 | Comparative Example 3 |
|---|---|---|---|---|---|
| Adhesion composition (parts by weight) | Photo cationic polymerizable compound | bisphenol-A type epoxy resin (Epicoat 828) | 40 | 40 | 40 |
| | | bisphenol-F type epoxy resin(Epicoat 807) | 40 | 40 | 40 |
| | Photo cationic polymerization initiator | ADEKA OPTOMER SP-170 | 1 | 1 | 1 |
| | Reaction modifier | polytetramethylene glycol (PTMG 1000) | 10 | - | - |
| | | propylene glycol addition bisphenol-A type epoxy resin (Rika Resin BPO-20E) | - | 10 | - |
| | Filler | styrene bead (diameter 5 µm) | 10 | 10 | 10 |
| Conditions of curing | | irradiation timing | irradiation before fabrication | | irradiation after fabrication |
| | | amount of irradiation (mJ/cm²) | 2400 | 2400 | 4800 |
| | | post-heating (60°C and 5 minutes) | none | none | - |
| Evaluation | Evaluation of curability | curability | ○ | ○ | ○ |
| | | curing time (minute) | 20 | 20 | - |
| | Cell evaluation | | ○ | ○ | × |

**Table 3**

| | | | Example 6 | Example 7 | Example 8 | Example 9 |
|---|---|---|---|---|---|---|
| Adhesion composition (parts by weight) | bisphenol-A Photo cationic resin polymerizable compound | type epoxy (Epicoat 828) | 40 | 40 | 40 | 40 |
| | | bisphenol-F type epoxy resin (Epicoat 4004) | 40 | 40 | 40 | 40 |
| | Photo cationic polymerization initiator | ADEKA OPTOMER SP-170 | - | 1 | 1 | 1 |
| | | Photoinitiator 2074 | 0.4 | - | - | - |
| | Reaction modifier | propylene glycol addition bisphenol-A type epoxy resin (Rika Resin BPO-60E) | 10 | 10 | 10 | 10 |
| | Sensitizer | DETX | 0. 2 | - | - | - |
| | Filler | styrene bead | 10 | 10 | 10 | 10 |
| | | calcium carbonate | - | 2 | - | - |
| | | amphoteric ionexchange resin (IXE600) | - | - | 2 | - |
| Conditions of curing | | irradiation timing | irradiation after fabrication | | | |
| | | amount of irradiation (mJ/cm²) irradiation | 2400 | 2400 | 2400 | 2400 |
| | | post-heating (60°C and 5 minutes) | none | none | none | none |
| Evaluation | Evaluation of curability | curability | ○ | ○ | ○ | ○ |
| | | curing time (minute) | 20 | 20 | 30 | 20 |
| | Cell evaluation | | ○ | ○ | ○ | ○ |
| | electrode coloration | | none | none | none | slightly present |

### (Examples 10)

### (1) Fabrication of organic EL device

A substance, which was fabricated by forming a film of ITO electrode in a thickness 100 nm on a glass substrate with a size of 25 mm × 25 mm × 0.7 mm, was used as a transparent supporting substrate. After this substrate was ultrasonically cleaned for 15 minutes with acetone and ultrasonically cleaned for 15 minutes with an alkaline aqueous solution, it was ultrasonically cleaned for 15 minutes with isopropyl alcohol, and further cleaned for 10 minutes with boiled isopropyl alcohol, and further treated at the last minute with UV-Ozone Cleaner ("NL-UV 253", manufactured by Nippon Laser & Electronics LAB.). Next, the above transparent supporting substrate was secured to a substrate holder of a commercially available vacuum evaporation apparatus (ULVAC, Inc.), and 200 mg of N,N'-di(1-naphthyl)- N,N'-diphenylbenzidine (α-NPD) was put in a biscuit crucible and 200 mg of tris(8-hydroxyquinoline)aluminum (Alq3) was put in another biscuit crucible, and the inside pressure of a vacuum chamber was reduced to 1 × 10⁻⁴ Pa. Further, the α-NPD-charged crucible was heated and α-NPD was deposited on the substrate at a vapor deposition rate of 15 Å/s to form a film of a hole transport layer having a film thickness of 600 Å. A substrate temperature at this time was room temperature. Without taking out this from a vacuum cell, another crucible of Alq3 was heated and a film of Alq3 was formed at a vapor deposition rate of 15 Å/s. After this, the transparent supporting substrates was taken out once from the vacuum chamber, and 200 mg of lithium fluoride was put in a resistive heating boat made of tungsten and 1.0 g of aluminum wire was wound around a tungsten filament. Next, the inside pressure of the vacuum cell was reduced to 2 × 10⁻⁴ Pa, and a film of lithium fluoride was formed at a vapor deposition rate of 0.2 Å/s in a film thickness of 5 Å, and then a film of aluminum was formed at a vapor deposition rate of 20 Å/s in a film thickness of 1,000 Å to fabricate a light-emitting device.

### (2) Preparation of adhesive

In a recovery flask (50 ml), a molecular sieve was put, and under absolutely dry condition, a mixture of 10 parts by weight of a propylene carbonate solution of a sulfonium salt type photo cationic polymerization initiator having a hydroxyl group ("SP-170" produced by Asahi Denka Co., Ltd.) and 5 parts by weight of phthalic anhydride were stirred for 5 hours in 100 parts by weight of toluene while being refluxed and reacted to obtain a reaction product. The obtained reaction product was dried under a reduced pressure and then purified with a column chromatography to obtain a highly polymerized photo cationic polymerization initiator.

Next, 1 part by weight of the obtained photo cationic polymerization initiator, 100 parts by weight of bisphenol A glycidyl ether ("EP828" produced by Japan Epoxy Resins Co., Ltd.) and 20 parts by weight of talc were adequately stirred by a planetary mixer and then deaerated under a reduced pressure to obtain a photo cationic polymerizable adhesive and this was used as an adhesive for sealing an organic EL device.

### (3) Sealing of device

After bonding a substance, to which the adhesive for sealing an organic EL device obtained in a glass can was applied with a syringe under a dry condition, to a substrate on the above light-emitting device, by irradiating ultraviolet light with a wavelength of 365 nm to the adhesive for sealing an organic EL device adhering to the periphery in such a way that the amount of irradiation is 2400 mJ/cm² using a super-high-pressure mercury lamp, the adhesive was cured to seal a light-emitting device.

### (4) Evaluation

On the obtained adhesive for sealing an organic EL device and the organic EL device sealed, evaluation was conducted according to the following methods. The results are shown in Table 4.

### (Measurement of quantity of out gas)

After the adhesive for sealing an organic EL device was applied in a thickness of 100 µm with a Baker type applicator, ultraviolet light with a wavelength of 365 nm was irradiated to a coat in such a way that the amount of irradiation is 2400 mJ/cm² using a high-pressure mercury lamp. Next, on the resulting coat, the rate of decrease of weight at a rate of temperature rise of 10°C/min and at 150°C was measured using a thermal analysis apparatus (Model: TG/DTA 6200 manufactured by Seiko Instrument Inc.) and this value was assumed to be the quantity of out gas of the coat.

### (Occurrence of dark spot)

The sealed organic EL device was left standing for 200 hours under the conditions of 40°C and 60% relative humidity (RH), and then the occurrence of dark spots and dark lines (i.e., non-luminous portions) was checked in energizing (10 V) the organic EL device.

### (Examples 11)

In an recovery flask (50 ml), a molecular sieve was put, and under absolutely dry condition, a mixture of 10 parts by weight of a sulfonium salt type photo cationic polymerization initiator ("CD-1012" produced by Sartomer Company Inc.), 1 part by weight of carbodiimide compound ("CARBODILITE oily resin modifier V-05" produced by Nisshinbo Industries, Inc.) and 1 part by weight of tolylene diisocyanate were stirred for 5 hours in 100 parts by weight of toluene while being refluxed and reacted, and then a reaction product was dried under a reduced pressure and purified with a column chromatography to obtain a highly polymerized photo cationic polymerization initiator.

Next, 1 part by weight of the obtained photo cationic polymerization initiator, 100 parts by weight of bisphenol A glycidyl ether ("EP828" produced by Japan Epoxy Resins Co., Ltd.) and 20 parts by weight of talc were adequately stirred by a planetary mixer and then deaerated under a reduced pressure to obtain a photo cationic polymerizable adhesive and this was used as an adhesive for sealing an organic EL device.

The organic EL device was sealed by the same procedure as in Example 1 except for using the obtained adhesive for sealing an organic EL device, and similar evaluation was conducted. The results are shown in Table 4.

### (Comparative Example 4)

An adhesive for sealing an organic EL device was obtained by the same procedure as in Example 1 except for using a sulfonium salt type photo cationic polymerization initiator having a hydroxyl group ("SP-170" produced by Asahi Denka Co., Ltd.) in place of a photo cationic polymerization initiator highly polymerized, and similarly, light with a wavelength of 365 nm was irradiated to the adhesive in such a way that the amount of irradiation is 2400 mJ/cm² to seal the device and similar evaluation was conducted. The results are shown in Table 4.

**Table 4**

| | Rate of decrease of weight (%) | Presence of Dark spot |
|---|---|---|
| Example 10 | 0. 20 | none |
| Example 11 | 0. 35 | none |
| Comparative Example 4 | 0.68 | slightly present |

### (Example 12)

### (1) Fabrication of thin film structure

A substance, which was fabricated by forming a film of ITO electrode in a thickness 100 nm on a glass substrate with a size of 25 mm × 25 mm × 0.7 mm, was used as a transparent supporting substrate. The transparent supporting substrates was ultrasonically cleaned for 15 minutes with acetone, ultrasonically cleaned for 15 minutes with an alkaline aqueous solution, ultrasonically cleaned for 15 minutes with ion-exchanged water, ultrasonically cleaned for 15 minutes with isopropyl alcohol, and ultrasonically cleaned for 10 minutes with boiled isopropyl alcohol, and then treated at the last minute with UV-Ozone Cleaner ("NL-UV253", manufactured by Nippon Laser & Electronics LAB.).

Next, this cleaned transparent supporting substrate was secured to a substrate holder of a vacuum evaporation apparatus (ULVAC, Inc.), and 200 mg of N,N'-di(1-naphthyl)-N,N'-diphenylbenzidine (α-NPD) was put in a biscuit crucible and 200 mg of tris(8-hydroxyquinoline)aluminum (Alq3) was put in another biscuit crucible, and the inside pressure of a vacuum chamber was reduced to 1 × 10⁻⁴ Pa.

Next, the α-NPD-charged crucible was heated and α-NPD was deposited on the transparent supporting substrate at a vapor deposition rate of 15 Å/s to form a film of a hole transport layer having a film thickness of 600 Å. A temperature of the transparent supporting substrate at this time was room temperature. Subsequently, without taking out the transparent supporting substrate provided with the above hole transport layer from a vacuum cell, another crucible of Alq3 was heated and Alq3 was deposited on the hole transport layer at a vapor deposition rate of 15 Å/s to form an organic thin film (luminescence layer) (Alq3 film) having a film thickness of 600 Å.

Next, the transparent supporting substrate provided with the hole transport layer and the luminescence layer was taken out once from the vacuum chamber, and 200 mg of lithium fluoride was put in a resistive heating boat made of tungsten and 1.0 g of aluminum wire was wound around a tungsten filament.

Next, the above transparent supporting substrate provided with the hole transport layer and the luminescence layer was set again within the vacuum chamber and the inside pressure of a vacuum cell was reduced to 2 × 10⁻⁴ Pa.

And the resistive heating boat made of tungsten was heated and lithium fluoride was deposited on the luminescence layer at a vapor deposition rate of 0.2 Å/s to form an electron injection layer having a film thickness of 5 Å, and then by heating the a tungsten filament to deposit aluminum on the electron injection layer at a vapor deposition rate of 20 Å/s and to form a film of cathode having a film thickness of 1,000 Å, a thin film structure was fabricated.

### (2) Fabrication of adhesive tape for sealing an organic EL device

As the photo cationic polymerizable compound, an epoxy resin (bisphenol A glycidyl ether, "Epicoat 828" produced by Japan Epoxy Resins Co., Ltd.) was used. And, as the photo cationic polymerization initiator, aromatic sulfonium hexafluoro antimonate ("ADEKA OPTOMER SP-170" produced by Asahi Denka Co., Ltd.) was used. And, as the adhesive resin, there was used polyester formed by copolymerizing 25 mole% of terephthalic acid, 25 mole% of isophthalic acid, ethylene glycol, 17.5 mole% of neopentyl glycol, 17.5 mole% of ethylene glycol adduct of bisphenol A and 25 mole% of tetramethylene ether glycol. Further, as the filler, talc was used.

80 parts by weight of the photo cationic polymerizable compound, 1 part by weight of the photo cationic polymerization initiator, 20 parts by weight of the adhesive resin, 20 parts by weight of the filler and 150 parts by weight of methyl ethyl ketone are homogeneously stirred and mixed at a stirring speed of 3,000 rpm using a HOMO DISPER type stirring mixer (trade name "HOMO DISPER L TYPE" manufactured by Tokushu Kika Kogyo Co., Ltd.) to prepare a resin composition.

The obtained resin composition was applied to a moisture-proof tape formed by laminating polyethylene terephthalate of 50 µm in thickness on both sides of aluminum foil of 7 µm in thickness in such a way that the applied thickness is 100 µm and dried to form the adhesive layer and to obtain the adhesive tape for sealing an organic EL device.

Further, to the adhesive layer of the obtained adhesive tape for sealing an organic EL device, a release treatment surface of a PET film, to which silicone release treatment has been applied, was laminated as a release film.

### (3) Sealing of thin film structure

After the release film of the resulting adhesive tape for sealing an organic EL device was peeled off, ultraviolet light with a wavelength of 365 nm was irradiated to the adhesive layer in such a way that the amount of irradiation is 2400 mJ/cm² using a super-high-pressure mercury lamp. Then, immediately, the outer surface of the thin film structure transferred into a glove box in which nitrogen gas was flown through was covered with the tape and the thin film structure was sealed by fixing the tape to the adhesive layer by pressure with hand to fabricate an organic EL device.

### (Example 13)

### (1) Fabrication of double-faced adhesive tape for sealing an organic EL device

A resin composition prepared by the same method as in Example 12 was applied to a PET film having a thickness of 50 µm (release film), to which release treatment has been applied, in such a way that the applied thickness is 100 µm using a bar coater and dried to form the adhesive layer. Further, as the adhesive layer, tubiform one, which can surround the hole transport layer, the luminescence layer, the electron injection layer and the cathode of the thin film structure inside thereof, was selected.

Next, a release treatment surface of the PET film (release film), to which silicone release treatment has been applied, was laminated to the surface of the adhesive layer, on which the PET film is not formed, as a protective film to obtain a double-faced adhesive tape for sealing an organic EL device.

### (2) Sealing of thin film structure

After the PET film as a protective film was peeled off from the resulting double-faced adhesive tape for sealing an organic EL device, ultraviolet light with a wavelength of 365 nm was irradiated to the adhesive layer in such a way that the amount of irradiation is 2400 mJ/cm² using a super-high-pressure mercury lamp. Then, immediately, the periphery portion, which is above the anode, of the hole transport layer, the luminescence layer, the electron injection layer and the cathode of the thin film structure, fabricated in Example 12, transferred into a glove box in which nitrogen gas was flown through, was covered with the adhesive layer in a state of being provided with the above PET film as a supporting material in such a way that the adhesive layer surrounds the periphery, and by peeling off the PET film as a supporting material, the adhesive layer was formed so as to surround the periphery, which is above the anode, of the hole transport layer, the luminescence layer, the electron injection layer and the cathode of the thin film. And, after coating the adhesive layer with a glass plate with a size of 25 mm × 25 mm × 0.7 mm, the thin film structure was sealed by fixing the glass plate to the adhesive layer by pressure with hand to fabricate an organic EL device.

### (Comparative Example 5)

The thin film structure prepared in Example 12 was used as an organic EL device without being sealed with a tape. When this organic EL device was left standing under the conditions of a temperature of 60°C and 90% relative humidity, it became non-luminous completely after 100 hours.

### (Example 14)

### (1) Fabrication of adhesive tape for sealing an organic EL device

As the photo cationic polymerizable compound, there was used an epoxy resin (bisphenol A glycidyl ether, "Epicoat 828" produced by Japan Epoxy Resins Co., Ltd.), and as the photo cationic polymerization initiator, there was used aromatic sulfonium hexafluoro antimonate ("ADEKA OPTOMER SP-170" produced by Asahi Denka Co., Ltd.), and as the adhesive resin, there was used a phenoxy resin (EP-1256 produced by Japan Epoxy Resins Co., Ltd.), and as the filler, talc was used.

30 parts by weight of epoxy resin, 1 part by weight of the photo cationic polymerization initiator, 70 parts by weight of phenoxy resin, 20 parts by weight of the filler and 150 parts by weight of methyl ethyl ketone are homogeneously stirred and mixed at a stirring speed of 3,000 rpm using a HOMO DISPER type stirring mixer (trade name "HOMO DISPER L TYPE" manufactured by Tokushu Kika Kogyo Co., Ltd.) to prepare a resin composition.

The resulting resin composition was applied to a moisture-proof tape comprising a multilayered film having a structure of easily adhesive polyester film (38 µm)/black-printed surface (5 µm)/aluminum foil (7 µm)/ polyester film (38 µm) in such a way that the applied thickness is 20 µm using a bar coater and dried to form the adhesive layer and to obtain an adhesive tape for sealing an organic EL device.

Further, to the adhesive layer of the obtained adhesive tape for sealing an organic EL device, a release treatment surface of a PET film, to which silicone release treatment has been applied, was laminated as a release film.

On the other hand, in order to measure the water vapor transmission rate and an out gas, the resin composition was applied to the PET film, to which release treatment has been applied, in such a way that the applied thickness is 100 µm and dried, and then laminated on the surface of the adhesive layer of the PET film, to which release treatment has been applied, to prepare a tape for measurement.

### (2) Sealing of thin film structure

After the release film of the resulting adhesive tape for sealing an organic EL device was peeled off, ultraviolet light with a wavelength of 365 nm was irradiated to the adhesive layer in such a way that the amount of irradiation is 2400 mJ/cm² using a super-high-pressure mercury lamp. Then, immediately, the outer surface of the thin film structure, fabricated in Example 12, transferred into a glove box in which nitrogen gas was flown through was covered with the tape and the thin film structure was sealed by fixing the tape to the adhesive layer by pressure with hand to fabricate an organic EL device.

### (Example 15)

A resin composition was prepared by the same procedure as in Example 12 except for using 25 parts by weight of Epicoat 828 and 10 parts by weight of phenyl glycidyl ether in place of 30 parts by weight of epoxy resin (Epicoat 828), and using this, an adhesive tape for sealing an organic EL device and an organic EL device were fabricated.

### (Comparative Example 6)

A resin composition was prepared by the same procedure as in Example 15 except for using an epoxy compound (Rika Resin BPO-20E produced by New Japan Chemical Co., Ltd.) having a bisphenol skeleton and an ethylene glycol skeleton in place of phenyl glycidyl ether, and using this, an adhesive tape for sealing an organic EL device and an organic EL device were fabricated.

### (Comparative Example 7)

A resin composition was prepared by the same procedure as in Example 13 except for using polyester formed by copolymerizing 25 mole% of terephthalic acid, 25 mole% of isophthalic acid, ethylene glycol, 17.5 mole% of neopentyl glycol, 17.5 mole% of ethylene glycol adduct of bisphenol A and 25 mole% of tetramethylene ether glycol in place of phenoxy resin, and using this, an adhesive tape for sealing an organic EL device and an organic EL device were fabricated.

### Evaluation

### (Light-emitting test under energization)

(1) The organic EL device obtained in Examples 12, 13 and Comparative Example 5 were left standing for 500 hours under the conditions of a temperature of 60°C and 90% relative humidity, and then each of the organic EL device was energized (10 V) and the presence of dark spots and dark lines (i.e., non-luminous portions) was visually observed. The results are shown in Table 5.
(2) The organic EL devices obtained in Examples 14, 15 and Comparative Examples 6, 7 were left standing for 500 hours under the conditions of a temperature of 40°C and 60% relative humidity, and then each of the organic EL devices was energized (10 V) and the presence of dark spots and dark lines (i.e., non-luminous portions) was visually observed. The results are shown in Table 5.

### (Measurement of water vapor transmission rate)

One separator of each of the resulting tapes for measurement obtained in Examples 14, 15 and Comparative Examples 6, 7 was peeled off and ultraviolet light with a wavelength of 365 nm was irradiated to the adhesive layer in such a way that the amount of irradiation is 2400 mJ/cm² using a super-high-pressure mercury lamp. Then the other separator was peeled off, and on the resulting tape, the water vapor transmission rate was measured by a dish method based on JIS Z 0208 (40°C and 24 hours). The results are shown in Table 5.

### (Out gas measurement)

Samples obtained in the measurement of the water vapor transmission rate were heated by raising a temperature at a rate of 10°C/min and a decrease in weight of samples in heating was measured by a thermal analysis apparatus (Model: TG/DTA 6200 manufactured by Seiko Instrument Inc.). The results are shown in Table 5.

**Table 5**

| | Presence of Dark spot | Water vapor transmission rate (g/cm² · 24hr) | Available time (minute) | Rate of decrease of weight (%) |
|---|---|---|---|---|
| Example 12 | none | - | - | - |
| Example 13 | none | - | - | - |
| Example 14 | none | 20 | 3 | 0.27 |
| Example 15 | none | 30 | 8 | 0.35 |
| Comparative Example 5 | not luminous | - | - | - |
| Comparative Example 6 | slightly present | 62 | 10 | 2.45 |
| Comparative Example 7 | slightly present | 43 | 10 | 0.83 |

### INDUSTRIAL APPLICABILITY

In accordance with the present invention, it is possible to provide an adhesive for sealing an organic electroluminescence device, an adhesive tape for sealing an organic electroluminescence device, a double-faced adhesive tape for sealing an organic electroluminescence device, a method of sealing an organic electroluminescence device and an organic electroluminescence device, which can seal an organic electroluminescence device without degrading it with light or heat.

## Claims

1. An adhesive for sealing an organic electroluminescence device,
which comprises a photo cationic polymerizable adhesive containing a photo cationic polymerizable compound and a photo cationic polymerization initiator and, initiating a curing reaction by light irradiation and proceeding the curing reaction by a dark reaction even after interrupting the light irradiation.

2. The adhesive for sealing an organic electroluminescence device according to claim 1,
wherein the photo cationic polymerizable compound is an aromatic epoxy resin.

3. The adhesive for sealing an organic electroluminescence device according to claim 1 or 2,
wherein the photo cationic polymerization initiator is a salt containing boronic acid expressed by the following formula (1); 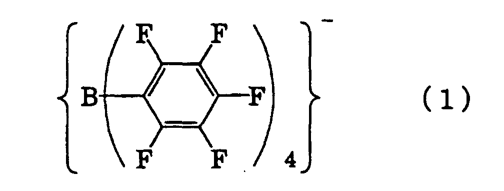 as a counter ion.

4. The adhesive for sealing an organic electroluminescence device according to claim 1, 2 or 3,
wherein the photo cationic polymerization initiator is a reaction product of a compound containing at least one hydroxyl group in a molecule and producing an acid by light irradiation and a compound containing two or more functional group being reactive with a hydroxyl group in a molecule.

5. The adhesive for sealing an organic electroluminescence device according to claim 1, 2 or 3,
wherein the photo cationic polymerization initiator is a reaction product of a compound containing two or more hydroxyl groups in a molecule and producing an acid by light irradiation and, carboxylic anhydride or dicarboxylic acid.

6. The adhesive for sealing an organic electroluminescence device according to claim 1, 2, 3, 4 or 5,
wherein the photo cationic polymerizable adhesive contains an aliphatic hydrocarbon having a hydroxyl group and/or a polyether compound.

7. The adhesive for sealing an organic electroluminescence device according to claim 1, 2, 3, 4, 5 or 6,
wherein the photo cationic polymerizable adhesive contains a filler.

8. The adhesive for sealing an organic electroluminescence device according to claim 1, 2, 3, 4, 5, 6 or 7,
wherein the photo cationic polymerizable adhesive contains an alkaline filler being reactive with acid and/or an ion-exchange resin adsorbing an acid.

9. The adhesive for sealing an organic electroluminescence device according to claim 1, 2, 3, 4, 5, 6, 7 or 8,
wherein the photo cationic polymerizable adhesive contains a drying agent.

10. A method of sealing an organic electroluminescence device using the adhesive for sealing an organic electroluminescence device according to claim 1, 2, 3, 4, 5, 6, 7, 8 or 9,
wherein after irradiating light to said adhesive for sealing an organic electroluminescence device, the device is sealed by filling the space between a sealing plate and a thin film structure with said adhesive for sealing an organic electroluminescence device before said adhesive for sealing an organic electroluminescence device is cured.

11. A method of sealing an organic electroluminescence device using the adhesive for sealing an organic electroluminescence device according to claim 1, 2, 3, 4, 5, 6, 7, 8 or 9,
wherein after irradiating light to said adhesive for sealing an organic electroluminescence device, the device is sealed by applying said adhesive for sealing an organic electroluminescence device so as to seal the periphery of the thin film structure and bonding the sealing plate to the applied adhesive before said adhesive for sealing an organic electroluminescence device is cured.

12. An adhesive tape for sealing an organic electroluminescence device,
which has a moisture-proof tape and an adhesive layer comprising the adhesive for sealing an organic electroluminescence device according to claim 1, 2, 3, 4, 5, 6, 7, 8 or 9, formed on at least one side of said moisture-proof tape.

13. The adhesive tape for sealing an organic electroluminescence device according to claim 12,
wherein the adhesive layer has the water vapor transmission rate, measure by a dish method based on JIS Z 0208 under the conditions of 60°C and 90% relative humidity (RH), of 30 g/(m²•24h)/100 µm or less.

14. The adhesive tape for sealing an organic electroluminescence device according to claim 12 or 13,
which has a drying agent in sheet form in the adhesive layer.

15. A method of sealing an organic electroluminescence device using the adhesive tape for sealing an organic electroluminescence device according to claim 12, 13 or 14,
wherein after irradiating light to the adhesive layer of said adhesive tape for sealing an organic electroluminescence device, the device is sealed by bonding the adhesive tape onto the thin film structure before the adhesive layer is cured.

16. A double-faced adhesive tape for sealing an organic electroluminescence device,
which has an adhesive layer comprising the adhesive for sealing an organic electroluminescence device according to claim 1, 2, 3, 4, 5, 6, 7, 8 or 9 and separators formed on both sides of said adhesive layer.

17. The double-faced adhesive tape for sealing an organic electroluminescence device according to claim 16,
wherein the adhesive layer has the water vapor transmission rate, measure by a dish method based on JIS Z 0208 under the conditions of 60°C and 90% relative humidity (RH), of 30 g/(m²•24h)/100 µm or less.

18. A method of sealing an organic electroluminescence device using the double-faced adhesive tape for sealing an organic electroluminescence device according to claim 16 or 17,
wherein after peeling off one separator of said double-faced adhesive tape for sealing an organic electroluminescence device and irradiating light to the adhesive layer on the side on which said separator has been peeled off, the device is sealed by bonding said double-faced adhesive tape for sealing an organic electroluminescence device so as to seal the periphery of the thin film structure and peeling off the other separator of said double-faced adhesive tape for sealing an organic electroluminescence device and further coating said adhesive layer with a sealing plate before said adhesive layer is cured.

19. An organic electroluminescence device,
which is sealed by using the adhesive for sealing an organic electroluminescence device according to claim 1, 2, 3, 4, 5, 6, 7, 8 or 9, the adhesive tape for sealing an organic electroluminescence device according to claim 12, 13 or 14, or the double-faced adhesive tape for sealing an organic electroluminescence device according to claim 16 or 17.
